# EUROPEAN PATENT SPECIFICATION

(11) **EP 0 598 409 B1**
(45) Date of publication and mention of the grant of the patent: **18.11.1998**
(21) Application number: 93118613.4
(22) Date of filing: 12.02.1990
(51) Int. Cl.: H01L 21/336, H01L 21/203, H01L 21/316

(54) **A method of manufacturing a semiconductor device**
Verfahren zur Herstellung einer Halbleitervorrichtung
Procédé pour fabriquer un dispositif semi-conducteur

(30) Priority: 14.02.1989 JP 34140/89; 27.03.1989 JP 74229/89; 27.03.1989 JP 74230/89; 05.06.1989 JP 142470/89; 04.10.1989 JP 259393/89; 21.11.1989 JP 302862/89
(43) Date of publication of application: 25.05.1994
(62) Divisional of application: 90102710.2
(73) Proprietor: SEIKO EPSON CORPORATION, Shinjuku-ku Tokyo-to (JP)
(72) Inventor: Oka, Hideaki, c/o Seiko Epson Corporation, Suwa-shi, Nagano-ken (JP); Takenaka, Satoshi, c/o Seiko Epson Corporation, Suwa-shi, Nagano-ken (JP); Kunii, Masafumi, c/o Seiko Epson Corporation, Suwa-shi, Nagano-ken (JP)
(74) Representative: Hoffmann, Eckart, Dipl.-Ing.

(56) References cited:
- DE-A- 3 241 959
- JP-A- 6 342 112
- US-A- 4 448 632
- US-A- 4 514 895
- JOURNAL A, Volume 28, No.4, 1987, pages 177-186

## Description

This invention relates to a method of manufacturing a semiconductor device, in particular, a semiconductor device on an insulating material.

Experiments have been performed to form high quality semiconductor elements on insulating materials, such as insulating amorphous substrates, for example, glass, quartz or the like, insulating amorphous layers, for example SiO₂, Si₃N₄ and the like, and so forth.

In recent years, expectations for improved high quality semiconductor elements formed on the foregoing insulating amorphous materials have been substantial as the needs for large, high resolution liquid crystal display panels, high speed, high resolution contact type image sensors, three dimensional ICs, and the like have increased.

In the case of, for example, forming a thin film transistor (TFT) on an insulating amorphous material, the following methods have been studied: (1) TFT comprising amorphous silicon formed by plasma CVD or the like as an element material, (2) TFT comprising polycrystalline silicon formed by CVD or the like as an element material, (3) TFT comprising single crystalline silicon formed by fusion recrystallization or the like as an element material, and the like.

However, realization of high quality TFTs has been very difficult because the field effect mobility of TFTs comprising amorphous silicon or polycrystalline silicon is substantially lower than that of TFTs comprising single crystalline silicon (amorphous silicon TFTs < 1 cm²/V.sec, polycrystalline silicon TFT about 10cm²/V.sec).

On the other hand, the fusion recrystallization technique employing a laser beam has not been quite complete yet, and many technical difficulties are encountered when elements are to be formed on a large area, such as liquid crystal display panel.

Thus, the method of forming large grain polycrystalline silicon by solid phase recrystallization was noticed, and the research has been proceeded. [Thin Solid Films Vol. 100 No. 3 (1983) P.227, JJAP Vol. 25 No. 2 (1986) p. L121]

However, the conventional method of the prior art is that, first polycrystalline silicon is formed by CVD, and after said polycrystalline silicon is amorphized by Si⁺ ion implantation, heat treatment is performed at approximately 600°C for nearly 100 hours. Because of that, there are such problems as: (1) since polycrystalline silicon is amorphized after it has once been formed, the process is complicated causing a cost up, (2) an expensive ion implantation system is necessary, (3) the heat treatment is extremely long, (4) it is very hard to handle a large substrate (for example, 30 cm x 30 cm), (5) the crystallized volume fraction after solid phase recrystallization is low and, therefore, it is very difficult to fabricate a high quality semiconductor device, and the like.

Journal A, Vol. 28, No. 4, page 177 to 186 (1987), discloses a control of a diffusion furnace for IC production wherein experiments are conducted with ramp-like temperature changes having a slope of 11.5 or 15°C/min.

A method according to the pre-characterizing portion of claim 1 is disclosed in JP-A-63-42112. In this prior art a polycrystalline film is formed on an amorphous substrate and subsequently thermally treated for recrystallization. The thermal treatment for recrystallization comprises two or more heat treatments at different temperatures.

The document DE-A-32 41 959 discloses to form a polycrystalline silicon layer having an average grain diameter of 20 nm or more by, e.g., a CVD method.

It is an object of this invention to provide means to realize a high quality semiconductor device by producing polycrystalline silicon with large grains and high crystallized volume fraction by employing easier and more practical methods.

This object is achieved with a manufacturing method as claimed.

Specific embodiments of the invention are subject of dependent claims.

Specific embodiments of the invention will be described below with reference to the drawings, in which:
- Fig. 1(a) to (d): show a manufacturing process of a semiconductor device according to a first embodiment of this invention.
- Fig. 2(a) to (d): show graphic illustrations of the temperature rise in a thermal treatment process according to an embodiment of this invention.
- Fig. 3(a) to (e): show graphic illustrations of temperature rise in a thermal treatment process according to another embodiment of this invention.
- Fig. 4(a) to (h): show a manufacturing process of a semiconductor device according to a second embodiment of this invention.
- Fig. 5(a) to (f): show a manufacturing process of a semiconductor device according to a third embodiment of this invention.
- Fig. 6(a) to (d): show a manufacturing process of a semiconductor device according to a fourth embodiment of this invention.
- Fig. 7: shows gate voltage - drain current characteristics of an n channel TFT of this invention.
- Fig. 8: shows gate voltage - drain current characteristics of a p channel TFT of this invention.

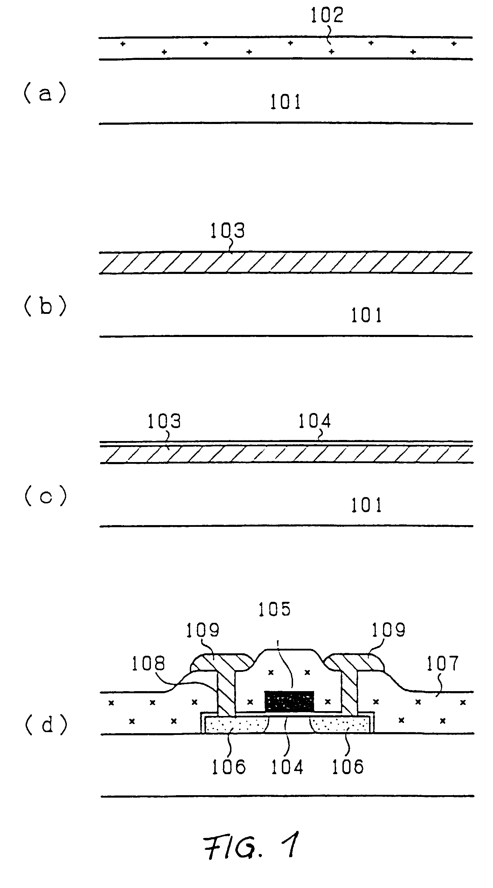

Fig. 1 shows one example of the manufacturing process of a semiconductor device employed in an embodiment of this invention. The case wherein a thin film transistor (TFT) is formed as a semiconductor element is shown as an example in Fig. 1.

Fig. 1(a) shows a process of forming a silicon layer 102 over an insulating material 101, such as an insulating amorphous substrate, for example, glass, quartz and the like, an insulating amorphous material layer, for example, SiO₂, Si₃N₄ and the like, and so forth. Other insulating crystalline substrates, such as a sapphire substrate (Al₂O₃), MgO.Al₂O₃, BP, CaF₂, and the like can also be employed as a substrate instead of quartz and glass. One example of the film growth condition is described hereinafter. When the substrate temperature is maintained approximately in the range of room temperature up to 600°C, monosilane or monosilane gas diluted with hydrogen, argon, helium, or the like is introduced to a reactive chamber and RF power is applied to dissociate the gas, then a silicon layer is formed at a thickness of about 0.01 - 0.2 µm on a desired substrate by plasma CVD. However, the method of forming the film is not limited to the foregoing.

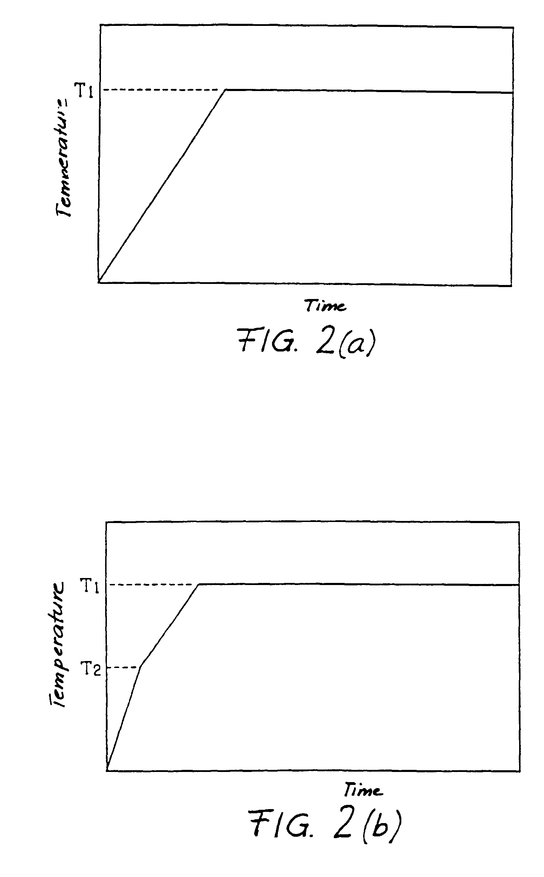

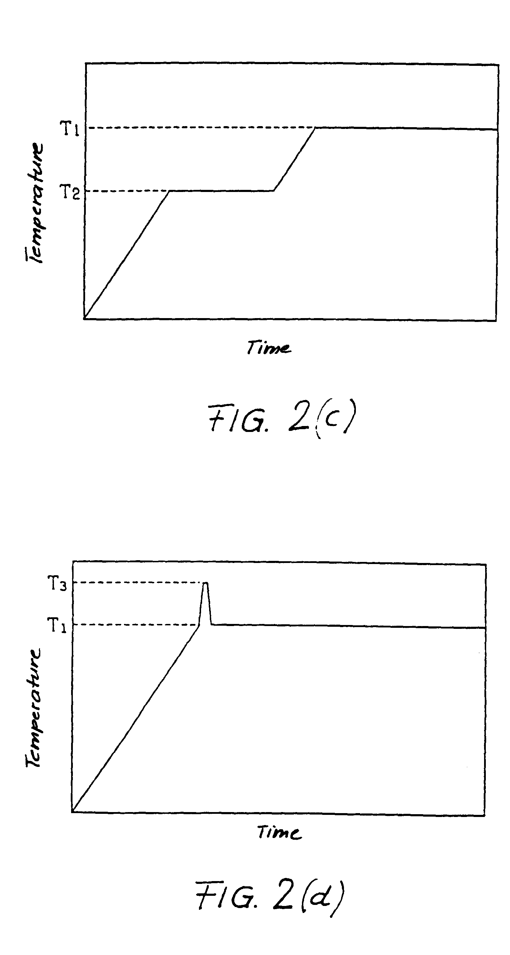

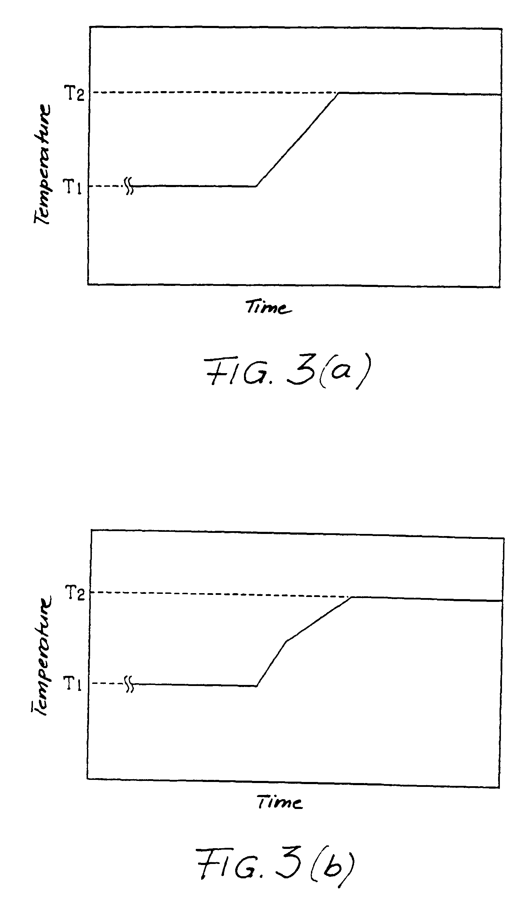

Fig. 1(b) shows a process of forming a polycrystalline silicon layer 103 via crystal growth by performing a thermal treatment on said silicon layer 102. The best condition of the thermal treatment differs depending upon the method of forming the silicon layer in process (a). For example, depending upon the substrate temperature difference at the time of forming the silicon layer, there are differences as follows:
(1) A film formed while the substrate temperature is in the range of room temperature up to 150°C, which is relatively low, becomes amorphous silicon containing a large amount of hydrogen in the film, however, hydrogen in the film can be removed by a thermal treatment at a lower temperature compared to a film formed in the temperature range of approximately 200 to 300°C. One example of a thermal treatment condition is described hereinafter. After an amorphous silicon film has been formed by plasma CVD, the film is annealed before vacuum is broken. Since an amorphous film formed at low temperature becomes porous, if it is taken out to the air as is after the film growth, then oxygen and the like will enter into the film rendering a low quality film. However, if the film is given proper thermal treatment before it is taken out to the air, then the film becomes dense, thereby preventing oxygen from entering in the film. The desirable thermal treatment temperature is over 300°C, and if the temperature is raised to approximately 400 to 500°C, substantially effective results can be achieved. Also, even when the thermal treatment temperature is lower than 300°C, film densification can be achieved. However, when annealing for solid phase recrystallization is continuously performed without breaking vacuum, the above annealing can be omitted.
   Next, said amorphous silicon film undergoes a thermal treatment for solid phase recrystallization. When thermal treatment of about 550°C to 650°C is performed for about several hours to 20 hours on an amorphous silicon film which was formed at low temperature, hydrogen removal and crystal growth occur, and polycrystalline silicon containing large grains of about ≥(1 to 2 µm) is formed. It is not desirable to raise the temperature of annealing for both achieving density and solid phase recrystallization to the prescribed degree suddenly in short time. The reason for this is that hydrogen removal in the film starts to occur as the temperature rises (especially over 300°C), and if the temperature rise speed is too high, defects in the film will occur more easily. In some cases pinholes may appear, and in other cases film separations may occur. If the temperature is gradually raised by less than 20°C/min (particularly, a rising temperature speed of less than 5°C/min is desirable.) at least when the annealing temperature is over 300°C, defects in the film will be less likely. The detailed explanation of the method of raising the temperature is described later in this text.
(2) The amount of hydrogen in a film is less if the film is formed when the substrate temperature is in the range of 150°C to 300°C compared to an amorphous silicon film formed at low temperature as described above; however, the temperature shifts to a higher degree when hydrogen removal starts. Since the film is more dense compared to the film formed at lower temperature, the annealing for achieving density can be omitted. When solid phase recrystallization is performed under the thermal treatment temperature of 550°C to 650°C for about several hours to 40 hours, then hydrogen removal and crystal growth occur, and polycrystalline silicon containing large grains of about 1 to 2 µm is formed. Although the detailed explanation of the method of raising the temperature to 550°C to 650°C is described later in this text, if the temperature is gradually raised by less than 20°C/min (particularly, a rising temperature speed of 5°C/min is desirable) when the annealing temperature is over 300°C, defects in the film will be less likely as was described in (1). Also, the substrate temperature of 150°C to 200°C is particularly desirable because large grains can be formed and film separation, which may occur during temperature rise to the prescribed degree for solid phase recrystallization does not occur easily.
(3) Although hydrogen in the film decreases even more when the substrate temperature exceeds 300°C, hydrogen removal is less likely to occur by annealing at the temperature of approximately 550°C to 650°C. Therefore, in some cases it becomes important to perform thermal treatment at a higher temperature than said temperature, and the description concerning this method will appear later in this text using Fig. 2(d).

The thermal treatment condition, particularly, the method of raising the temperature to the prescribed degree is described hereinafter. Fig. 2 shows graphic illustrations of examples of the method of raising the temperature in an embodiment of this invention. Fig. 2(a) shows the case wherein, first, the temperature is raised to the prescribed level (T₁) at the specified temperature rise speed and then annealing is performed at this prescribed level (T₁). As it was mentioned previously, the desirable temperature rise speed is less than 20°C/min (preferably it is 5°C/min) so that occurrence of defects associated with hydrogen removal is suppressed. Also, the temperature rise speed need not be constantly the same, but it can fluctuate within the foregoing range. Fig. 2(b) shows the case wherein, first, the temperature is raised to the prescribed level (T₂) at the specified temperature rise speed, then the temperature is further raised to the annealing temperature of T₁ by a lower temperature rise speed. The reason for the change of the temperature rise speed around T₂ is that, as it was mentioned previously, hydrogen removal in the film starts at a temperature higher than about 300°C. Therefore, after hydrogen removal has started, the temperature rise speed is slowed down to less than 20°C/min (preferably 5°C/min) so as to suppress the occurrence of defects (it also contributes to shorten the temperature rise time.) The desirable level of T₂ is about 250°C to 400°C. Also, as in the case of Fig. 2(a), the temperature rise speed need not be constantly the same. Further, when the temperature rise speed is changed around T₂, this does not have to be sudden, but it can be changed gradually. Also, there may be a stepwise change with a plurality of intermediate temperatures like T₂. Fig. 2(c) shows the case wherein, first, the temperature is raised to T₂, then T₂ is maintained for a certain time and then the temperature is further raised to the annealing temperature of T₁. A large amount of hydrogen in the film can be removed without generating polycrystalline nuclei by maintaining a temperature lower than the annealing temperature for a certain time (for example, about 20 minutes to 2 hours). Thus, even when the temperature is raised fast to the annealing temperature for solid phase recrystallization after maintaining T₂ for a certain time, the occurence of defects associated with hydrogen removal is less likely to occur. The desirable value of T₂ is about 350°C to 550°C. T₂ need not be constantly the same. For example, it is alright to slowly raise the temperature by less than 5°C/min. There may be a stepwise change with a plurality of intermediate temperatures like T₂ also. For example, after maintaining the temperature at about 350°C, the temperature can be again maintained around 500°C. By doing so, hydrogen in the film can be removed more completely suppressing the occurence of defects in the film at the same time. Fig. 2(d) shows the case wherein, first, the temperature is raised to the annealing temperature of T₁, then the temperature is raised in a period of several minutes to T₃, which is higher than the annealing temperature, then the temperature is cooled down to T₁ in a period of several minutes and then annealing is performed at T₁. By having the step of raising the temperature to T₃, crystalline growth can be progressed with complete hydrogen removal, compared to the time when crystalline growth is hindered by hydrogen in the film at the time of annealing at about 550°C to 650°C. The desirable value of T₃ is about 700°C to 800°C. It is necessary to keep the time for raising the temperature to and cooling down from T₃ short (preferably within the range of 1 to 10 minutes) in order to suppress generation of polycrystalline nuclei. Therefore, lamp annealing is effective to raise the temperature to T₃ in short time. It is also possible to suppress occurrence of defects even more by combining a plurality of the methods in Fig. 2(a) - (d). Further, Fig. 2(a) - (d) are just examples and this invention is not limited to those embodiments. The important point is the realization of a manufacturing method of forming polycrystalline silicon by solid phase recrystallization with large size grains from amorphous silicon formed by plasma CVD, which was considered difficult previously. (Although amorphous silicon films can be produced in quantities by plasma CVD and they can be applied in a large area, since the hydrogen content in the film is large and the hydrogen hinders solid phase recrystallization, it was thought that this was not a desirable method for forming an amorphous silicon film on which solid phase recrystallization is to be performed.)

Fig. 1(c) shows a process of forming a gate insulation film 104 by oxidizing said polycrystalline silicon layer 103 by thermal oxidation. The gate oxidation temperature is approximately 1,000°C to 1,200°C. Polycrystalline silicon layer 103 was formed by solid phase recrystallization described in the process (b), however, the crystallized volume fraction is not necessarily high. Especially, when a silicon film formed by plasma CVD (amorphous silicon or micro-crystalline silicon, which has minute crystal regions in the amorphous phase were generated) is formed by solid phase recrystallization, the crystallized volume fraction is low at approximately 40% to 85% (it varies depending upon the film growth condition and solid phase recrystallization). Our study confirmed, therefore, that in the case of oxidizing said polycrystalline silicon layer by thermal oxidation, if the temperature is raised to a high value of 1,000°C to 1,200°C suddenly in short time, crystallinity of the remaining (60% to 15%) amorphous regions is damaged. Presently, the relation of the cause and effect is not clear, however, some assumptions made are as follows:

When the temperature is raised suddenly, (1) many crystal nuclei are generated in the amorphous region, thereby forming many minute crystal grains, (2) crystallization in the amorphous region during the process of temperature rise and thermal oxidation does not progress very much, (3) remaining hydrogen in the film suddenly removes during temperature rise causing defects. In order to solve these problems, we have invented means to substantially improve crystallinity of polycrystalline silicon layers by controlling the temperature rise speed and the method of raising the temperature to the thermal oxidation temperature of 1,000°C ^{~} 1,200°C.

Also, it was confirmed that the substrate temperature of a film formed by plasma CVD and the method of temperature rise at the time of gate oxidation have a profound relationship. That is, (1) the higher the substrate temperature is, the smaller the amount of hydrogen content in the film. When the substrate temperature is over 350°C, preferably over 400°C, hydrogen content in the film decreases extremely. Thus, the occurrence of defects associated with hydrogen removal during the temperature rise to the solid phase recrystallization temperature of 550°C to 650°C decreases. However, since the temperature at which hydrogen removes almost completely from the film shifts to a higher temperature compared to the case when a film is formed at low temperature, as it will be mentioned later in the text, it is very important to optimize the temperature rise speed, the method of temperature rise, and the like when the temperature is raised to the gate oxidation temperature of 1,000°C to 1,200°C. Also, since in the case of solid phase recrystallization performed on a film which was formed at the substrate temperature of over about 550°C, polycrystalline silicon or micro-crystalline silicon whose orientation is <110> can be obtained, it is effective in lowering TFT Si/SiO₂ interface state density and improving field effect mobility. (2) Since a large amount of hydrogen is contained in a film formed at the substrate temperature lower than around 350°C, it is, therefore, important to remove hydrogen in the film in order to avoid occurrence of many defects in the film before solid phase recrystallization at about 550°C to 650°C is performed. When hydrogen removal is performed under a desirable condition, there is a tendency that the lower the film growth temperature is, the larger the polycrystalline silicon grains will become. However, since the lower the temperature is, the lower the crystallized volume fraction after the solid phase recrystallization becomes, as it is described later in the text, it is important to optimize the temperature rise speed, the method of temperature rise, and so forth after the solid phase recrystallization. It became evident that performing thermal treatment after solid phase recrystallization at about 550°C to 650°C based on this invention is effective for a thin film formed by other film growth methods besides plasma CVD. Particularly, this invention is very effective for the film with low polycrystalline nucleus generation density at the time of solid phase recrystallization (i.e., polycrystalline silicon with large grains can be easily obtained by solid phase recrystallization).

An amorphous silicon film formed by plasma CVD contains less contaminants, e.g. oxygen (O), nitrogen (N), or carbon (C), compared to the amorphous silicon film formed by electron beam evaporation or LPCVD. Thus, a polycrystalline silicon film with high purity has been obtained by solid phase recrystallization on the amorphous silicon film by plasma CVD.

Also, less contaminants in an amorphous silicon film makes it easy to promote solid phase recrystallization, which results in obtaining a polycrystalline silicon film with a large grain size. In particular, the amorphous silicon deposited at a temperature range of about 150°C to 350°C contains the lowest amount of contaminants which is derived from an insulating support, and a reactor chamber of PCVD. On the other hand, the amorphous silicon deposited at a temperature range of about room temperature to 150°C releases hydrogen easily by heat treatment, which makes heat treatment time short.

The amount of C and O in an amorphous silicon formed by PCVD can be reduced to the order of 10E17 to 10E18 cmE-3.

Particularly, it is also possible to reduce the amount of C and O to less than 10E16 by improving purity of gas source, and suppressing generation of contaminants from the inner wall of the reactor chamber.

As an example, a very important relationship between the film growth temperature of a film formed by LPCVD and the method of temperature rise at the time of gate oxidation is described hereinafter. When comparing a silicon layer formed at high temperature (for example, about 580°C to 610°C) to a silicon layer formed at low temperature (for example, about 500°C to 550°C), if the temperature rise to the gate oxidation temperature is sudden, the crystallized volume fraction of the silicon layer formed at low temperature is lower, and TFT field effect mobility is smaller. However, when the method of temperature rise of this invention is employed, inversely, a silicon layer formed at low temperature formed larger grains and achieved higher crystallized volume fraction and higher field effect mobility.

The suspected reasons are (1) a film formed at a low temperature of 500°C to 550°C by PCVD became amorphous silicon or micro-crystalline silicon containing minute crystalline regions in the amorphous phase. Therefore, compared to a film formed at high temperature, polycrystalline nucleus generation density at the time of solid phase recrystallization is lower and, therefore, polycrystalline silicon with large grains can be obtained by solid phase recrystallization, (2) however, crystalline quality was damaged in the film formed at low temperature when the temperature was raised suddenly at the time of gate oxidation because of the large amorphous phase ratio after the solid phase recrystallization.

Therefore, this invention is effective in the following cases besides for a film formed by LPCVD and CVD: (1) in the case wherein amorphous silicon or micro-crystalline silicon is formed by vapor deposition, EB vapor deposition, MBE, sputtering, ECR-PCVD, or the like, (2) after micro-crystalline silicon, polycrystalline silicon is formed by plasma CVD, CVD, ECR-PCVD, vapor deposition, EB vapor deposition, MBE, sputtering, or the like and then ion implantion of Si, Ar, or the like is performed to form complete amorphous silicon or partially amorphous silicon from said micro-crystalline silicon or polycrystalline silicon. Especially, this invention is effective for a film whose amorphous phase ratio of as-deposited film is high and polycrystalline nucleus generation density is low (i.e., polycrystalline silicon with large grains can easily be obtained by solid phase recrystallization).

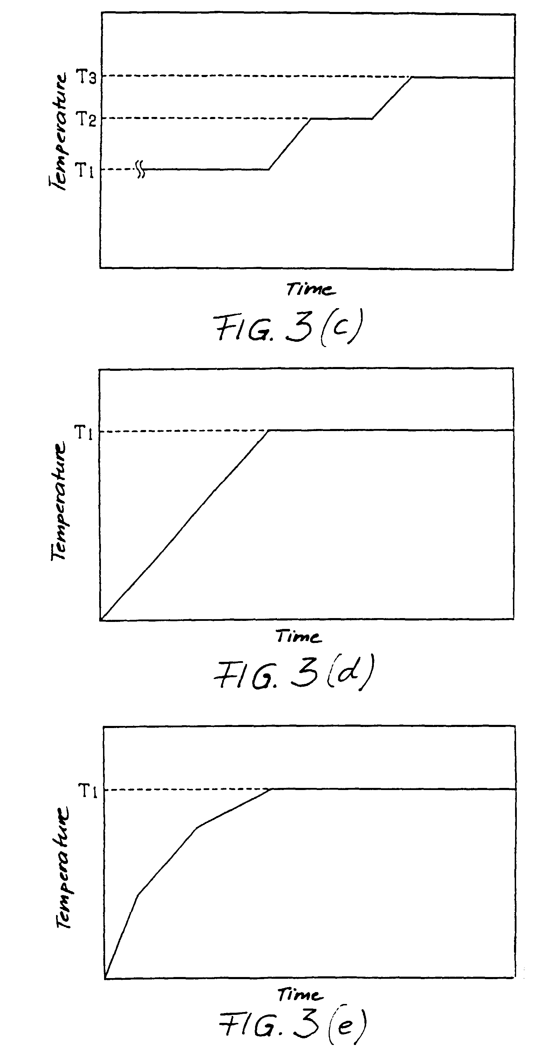

Next, thermal treatment conditions of this invention, in particular, the method of raising the temperature to a prescribed degree (for example, gate oxidation temperature) is described hereinafter. Fig. 3 shows graphic illustrations of examples of a temperature rise in one embodiment of this invention. Fig. 3(a) shows, as it was shown in Fig. 1(b), the case wherein annealing is performed in an inert gas atmosphere, such as argon, nitrogen, or the like at a prescribed temperature (T₁) to perform solid phase recrystallization on silicon layer 102 to form polycrystalline silicon layer 103, then gate oxidation is performed after the temperature is raised at a specified speed to the prescribed gate oxidation temperature (T₂). When the temperature rise speed from T₁ to T₂ is lower than about 20°C/min (preferably 5°C/min), it is desirable because the crystallized volume fraction after gate oxidation is high. There is another method wherein while the temperature is raised, the atmosphere is changed from an inert gas atmosphere, such as argon, nitrogen, or the like to the atmosphere containing at least one or more gas from oxygen, water vapor, hydrogen chloride, or the like to promote oxidation. (This method can be applied to the method described hereinafter.) The temperature rise speed need not be constantly the same, but it can fluctuate within the foregoing range. Also, there is another method wherein the sample is taken out after thermal treatment has been performed at T₁ and then again the temperature is raised to T₂ at a specified speed. For example, after solid phase recrystallization a sample is taken out once then placed into an oxidation chamber which is maintained at a prescribed temperature of 600°C to 900°C (preferably 600°C to 750°C). Then, the temperature is raised slower than by about 20°C/min (preferably 5°C/min), to the gate oxidation temperature. However, when thermal treatment was performed continuously without taking the sample out, crystalline quality was better because less impurity was introduced to the film.

Fig. 3(b) shows, as it was shown in Fig. 1(b), the case wherein annealing is performed on silicon layer 102 for solid phase recrystallization at the prescribed temperature (T₁) in order to form polycrystalline silicon layer 103. Then, the temperature is raised to the gate oxidation temperature (T₂) at a speed becoming lower as the temperature becomes higher, and gate oxidation is performed. Especially, when the temperature exceeds the range of about 800°C to 1,000°C, the desirable temperature rise speed is lower than 5°C/min. On the other hand, when the temperature is lower than about 700°C, temperature rise can be faster than 10°C/min.

Fig. 3(c) shows, as it was shown in Fig. 1(b), the case wherein annealing is performed at the prescribed temperature (T₁) on silicon layer 102 by solid phase recrystallization, and polycrystalline silicon layer 103 is formed. Then the temperature is raised to a prescribed value (T₂) at a prescribed temperature rise speed, and after it has been maintained for a certain time, the temperature is raised to the prescribed gate oxidation temperature (T₃). By maintaining the temperature T₂ lower than the gate oxidation temperature (T₃) for a certain time (for example, 10 min to 1 hour) the crystallization ratio can be raised without damaging the crystalline quality. Therefore, in the case when the temperature is raised to the gate oxidation temperature at a fast temperature rise speed after the temperature maintained at T₂ for a certain time, defects occur less likely. The desirable value of T₂ is in the range of about 700°C to 900°C. The prescribed temperature (T₂) need not be constantly the same. For example, the temperature can be raised slower than 5°C/min. Also, there may be stepwise change with a plurality of intermediate temperatures like T₂. For example, after the temperature was maintained at about 700°C, it can be maintained again around 800°C. This is effective to lessen defects in the film.

Fig. 3(d) shows the case wherein gate oxidation is performed after the temperature has been raised to the gate oxidation temperature (T₁) at a specified temperature rise speed. It contributes to shorten the process time because it does not need a special stage for solid phase recrystallization wherein the temperature need to be maintained at a specified level because solid phase recrystallization progresses while the temperature is raised. The desirable temperature rise speed is less than 5 to 10°C/min (preferably 2°C/min) to achieve a high crystallization ratio because solid phase recrystallization progresses while the temperature is rising. The temperature rise speed need not be fixed, but it can fluctuate within the foregoing range.

Fig. 3(e) shows the case wherein gate oxidation is performed after the temperature has been raised to the gate oxidation temperature (T₁) at a speed becoming lower as the temperature becomes higher. Especially, when the temperature exceeds the range of about 700°C to 1,000°C, the desirable temperature rise speed is lower than 5°C/min (preferably 2°C/min), because the crystalline quality of polycrystalline silicon improves. On the other hand, when the temperature is lower than about 250°C, even if the temperature rise speed is faster than 40°C/min, there is almost no effect on the crystalline quality of polycrystalline silicon, therefore, it contributes to shorten the process time. Since in the range of about 300°C to 500°C hydrogen removal progresses, the desirable temperature rise speed is lower than 5 to 10°C/min (preferably 2°C to 4°C/min). Since in the range of about 500°C to 700°C solid phase recrystallization progresses, the desirable temperature rise speed is lower than 5°C/min (preferably 2°C/min).

Also, it is possible to suppress occurrence of defects by combining a plurality of the Fig. 3(a) to (e) methods and improve crystalline quality and crystallization ratio. Fig. 3(a) to (e) are just examples of this invention and this invention is not limited to those embodiments.

Fig. 1(d) shows a process of forming a semiconductor device. With reference to Fig. 1(d), the case wherein a TFT is formed as a semiconductor element is described as an example. In the figure, 104 is a gate insulator film, 105 is a gate electrode, 106 is a source/drain region, 107 is an interlevel insulator, 108 is a contact hole, and 109 is an interconnection. One example of forming a TFT is as follows: After a gate electrode has been formed, a source/drain region is formed by ion implantation, thermal diffusion, plasma doping, or the like, and an interlevel insulator is formed by CVD, sputtering, plasma CVD, or the like. Further, contact holes are made in said interlevel insulator, and interconnections are formed.

In this embodiment, the case of performing gate oxidation is employed as an example of a high temperature thermal treatment, however this invention is not limited to that. For example, it is sufficient to perform only a thermal treatment at a prescribed temperature (for example, about 700°C to 1,200°C) after raising the temperature at a specified temperature rise speed. In this case, the method of forming a gate insulation film is not limited to thermal oxidation, but CVD, sputtering, plasma CVD, ECR-PCVD, and the like are also good. However, in the case when a gate insulation film of an insulated gate type semiconductor element is formed by thermal oxidation, performing said thermal treatment also works as a thermal oxidation process contributing to shorten the process time.

Further, by including a process of exposing a semiconductor element to a plasma atmosphere containing at least hydrogen gas or ammonia gas, in said TFT manufacturing process, and said TFT is hydrogenated, the defect density existing in grain boundaries decreases, and said field effect mobility improves even more.

The field effect mobility ratio of a polycrystalline silicon TFT (N channel) formed based on the manufacturing method of this invention is 150 to 200cm²/V·sec, and high quality polycrystalline silicon TFTs can be manufactured by an easy process.

The polycrystalline silicon film formed by this invention is not limited to insulating gate type field effect transistors in its application, but it is also applicable to bipolar transistors, static induction transistors, and opto-electric transducers such as solar cells or the like. This invention produces a high quality polycrystalline silicon film having a carrier mobility in excess of 150 cm²/V.sec.

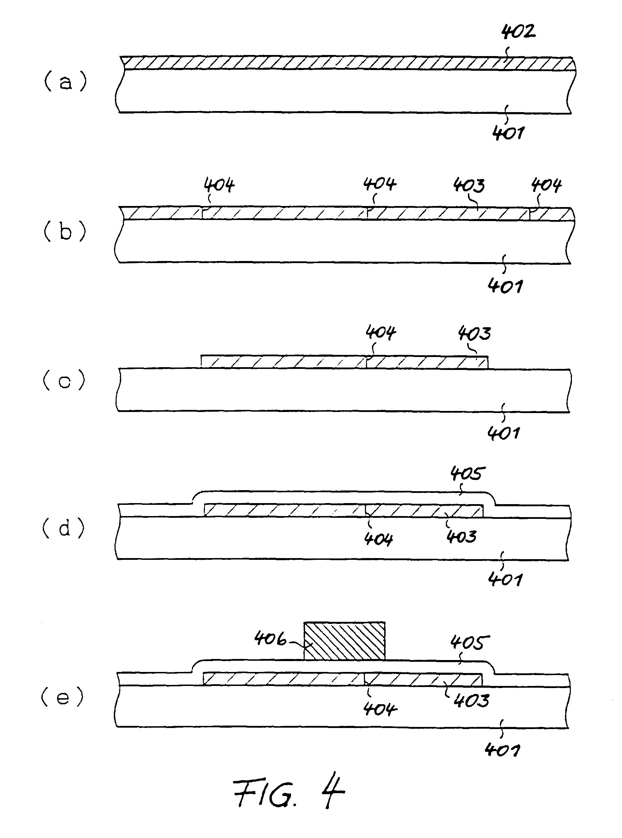

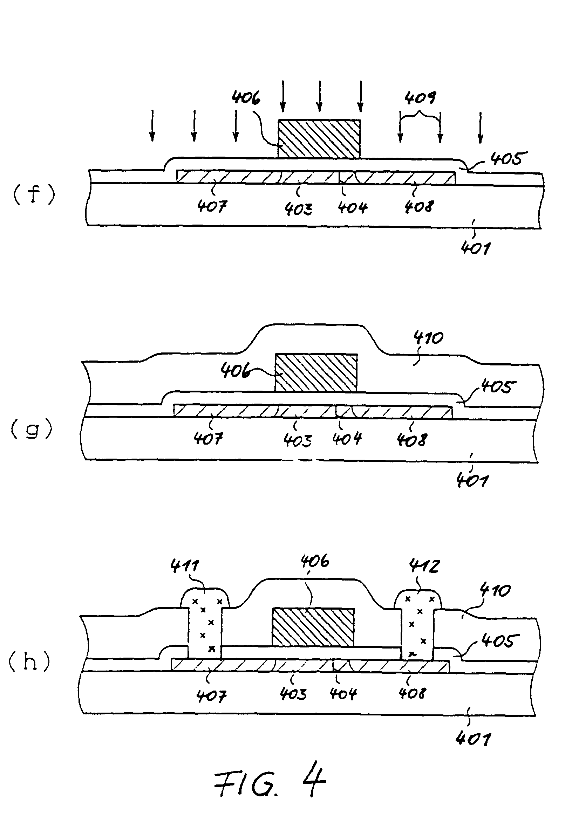

It is also extremely effective to dope impurities in the channel region to control the threshold voltage Vth. In a polycrystalline silicon TFT formed by solid phase recrystallization, there is a tendency for Vth of an N channel transistor to shift to the depletion direction, and a P channel transistor to the enhancement direction. Also, when said TFT becomes hydrogenated the tendency becomes even more conspicuous. Now, if impurities of about 10¹⁵ to 10¹⁹/cm³ are doped at the channel region, the shift of Vth can be suppressed. For example, in Fig. 1(d), there is a method of implanting impurities containing boron by an amount of approximately 10¹¹ to 10¹³/cm² by ion implantation before the gate electrode is formed. Especially, when the doping is performed by the above mentioned amount, Vth can be controlled to minimize OFF current in both P channel transistors and N channel transistors. Therefore, in the case of forming a CMOS type TFT element, the entire channel can be doped in a single process without selectively doping P channel and N channel. Further, besides the method of doping impurities in the channel region by the foregoing ion implantation, there is another effective method of doping, which is mentioned later, wherein impurities are doped during film growth and the film is formed by solid phase recrystallization. This manufacturing method is described hereinafter using Fig. 4.

Fig. 4(a) shows a process of forming a boron doped amorphous silicon layer 402 on an insulating material 401, such as an insulating substrate of glass, quartz or the like, an insulating material layer of SiO₂, Si₃N₄ or the like, and so forth.

In order to form said boron doped amorphous silicon layer, deposition is performed by dissociating silane gas (SiH₄) diluted with helium gas (He) or hydrogen gas (H₂) to make appropriate concentration and applying RF power to promote the dissociation. In the case of forming boron doped amorphous silicon layers, diborane gas (B₂H₆) is added to said gas and RF power is applied to promote gas dissociation. By controlling the boron doping amount approximately within the range of 1 x 10¹⁵ to 1 x 10¹⁹/cm³ by changing the mixture ratio of silane gas and diborane gas, Vth can be controlled.

Fig. 4(b) is a process of performing solid phase recrystallization on said boron doped amorphous silicon layer. The method of solid phase recrystallization is the same as that of in the embodiment shown in Fig. 1. In Fig. 4(b), 403 represents the boron doped silicon layer which was formed by solid phase recrystallization, and 404 represents grain boundaries. Amorphous silicon layers containing impurities, such as boron or the like are more easily recrystallized compared to undoped silicon layers, and they contain grains of ≥ 2µm, and there are even grains of ≥ 4µm.

Fig. 4(c) shows a process wherein the boron doped silicon layer 403 formed by solid phase recrystallization is made to an insular shape by photolithography patterning. Fig. 4(d) shows a process of forming a gate insulation film 405. The description of the method of forming the gate insulation film is omitted here since it is the same as that of the embodiment shown in Fig. 1.

Fig. 4(e) shows a process of forming a gate electrode 406. A polycrystalline silicon thin film, a molybdenum silicide, a metal film, such as aluminum, chrome, or the like, or a transparent conductive film, such as ITO, SnO₂, or the like can be employed as said gate electrode material. Some methods of forming the film are CVD, sputtering, vacuum evaporation, and the like.

Fig. 4(f) shows a process of forming a source region 407 and a drain region 408 by self-alignment via ion implantation employing said gate electrode 406 as a mask. When fabricating an N channel transistor, P⁺ or As⁺, and for a P channel transistor, B⁺ or the like can be used as impurities. The methods of adding impurities besides ion implantation are laser doping, plasma doping, and the like. The arrows represented by 409 show ion beams of impurities. A thermal diffusion method can be employed when a quartz substrate is used as said insulating substrate 401.

Fig. 4(g) shows a process of forming an interlevel insulator 410. An oxide film or a nitride film can be employed as said interlevel insulating material. The film thickness can be of any value if the insulation quality is good, however, the conventional thickness is in the range of approximately several hundred nm to several µm. Easy methods for forming a nitride film are LPCVD, plasma CVD, and the like. A mixture of ammonia gas (NH₃), silane gas, and nitrogen gas or a mixture of silane gas and nitrogen gas is used for reaction.

Now, when hydrogen is introduced by a hydrogen plasma method, hydrogen ion implantation, a hydrogen diffusion method from a plasma nitride film, or the like, then defects existing around the Si/SiO₂ interface and grain boundaries, such as dangling bonds or the like, can be inactivated. This kind of hydrogenation process can be performed before forming plural layers of interlevel insulator 410.

Fig. 4(h) shows a process wherein contact holes are formed in said interlevel insulator 410 and gate insulation film, and a contact electrode is formed to make source electrode 411 and drain electrode 412. Said source electrode and drain electrode comprise a metallic material, such as aluminum or the like. This is how a thin film transistor is fabricated.

There are the following merits in controlling Vth by solid phase recrystallization by doping impurities during the film growth.
(1) Since there is no need for an expensive equipment, such as an ion implantation system, it is advantageously inexpensive. Also, there is absolutely no increase in the number of processes.
(2) Since a boron doped amorphous silicon thin film is formed by solid phase recrystallization compared to the prior art case when a non-doped amorphous silicon thin film is formed by solid phase recrystallization, a silicon thin film containing larger grains can be obtained. As a result, the larger the grain size becomes, the greater the increase in ON current of the thin film transistor is.

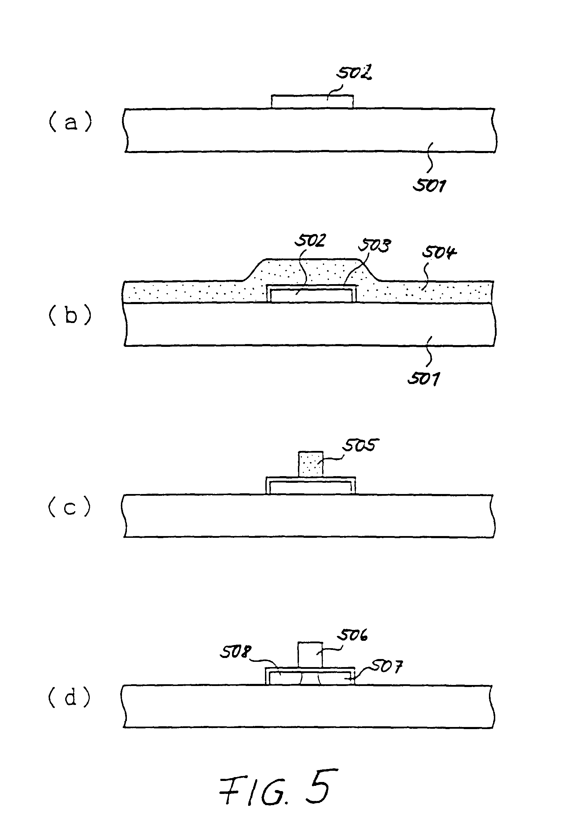

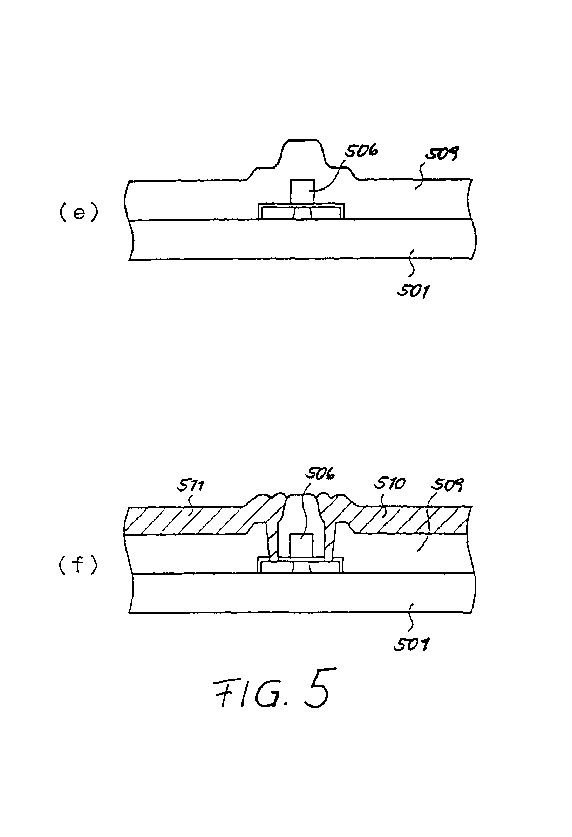

As described above, when a thin film transistor is manufactured employing a polycrystalline silicon thin film with large grains made of a boron doped amorphous silicon thin film by solid phase recrystallization, controlling the threshold voltage is realized by an easy process. The method of forming a doped polycrystalline silicon thin film with large grains by solid phase recrystallization during the film growth is also advantageous as a means to form materials for gate electrodes and interconnections. Based on Fig. 5, the description of an embodiment follows hereinafter employing a manufacturing method of a semiconductor device of this invention. In this embodiment, amorphous silicon is employed for a description purpose as an example of an amorphous semiconductor, however, amorphous Ge, amorphous SiGe, and the like can also be applied.

Fig. 5(a) shows a process wherein an amorphous or polycrystalline silicon layer 502 is formed at a thickness of about 0.01 to 0.2 µm by plasma chemical vapor deposition (PCVD) low pressure chemical vapor deposition, (LPCVD), or the like over an insulating amorphous material 501. Then, etching is performed on this silicon layer to form a prescribed pattern, and if it is required solid phase recrystallization, laser annealing, or the like is performed to obtain larger grains either before or after forming the pattern. Next, an insulating film 503 comprising an SiO₂ layer is formed over the silicon layer at a thickness of about 0.03 to 0.15 µm by thermal oxidation, sputtering, or the like.

Fig. 5(b) shows a process wherein an amorphous silicon layer 504 is formed over said SiO₂ layer at a thickness of about 0.3 to 0.7 µm by PCVD, ECR-PCVD, sputtering, Si ion implantation on a polycrystalline silicon thin film, or the like. PCVD is employed as an example for a description purpose in this embodiment. SiH₄ and H₂ gas are employed as the film growth gas in PCVD, and PH₃ gas or B₂H₆ gas is employed as the doping gas. In the case PH₃ is employed, N⁺ polycrystalline silicon can be formed, and in the case B₂H₆ is employed, P⁺ polycrystalline silicon can be formed. The substrate temperature was 180 to 250°C, the internal pressure was 107 Pa (0.8 Torr), and 13,56 MHz RF power was employed. The flux ratio of PH₃ or B₂H₆ and SiH₄ was set so that the P or B concentration would be 1 x 10¹⁶ to 1 x 10²² cm⁻³.

Fig. 5(c) shows a process wherein the previously formed amorphous silicon layer 504 is formed to have the pattern of gate electrode 505, and then solid phase recrystallization is performed. The solid phase recrystallization can be performed before the pattern forming. The substrate under this condition is preannealed at 450°C for 30 minutes in N₂ to remove hydrogen contained in the amorphous silicon layer. The purpose of this step is to avoid producing a porous film because if solid phase recrystallization annealing is performed while the amorphous silicon contains hydrogen, the parts where hydrogen is removed become void. Also, there are various other types of thermal treatment before the solid phase recrystallization as shown in Fig. 2 besides the foregoing method. PCVD has a merit in that if the gas for film growth is diluted with He gas, the amount of hydrogen which will be introduced into the amorphous silicon layer can be reduced. After this step, solid phase recrystallization annealing is performed. The annealing is performed in N₂ gas at 550 to 650°C for several hours to 40 hours. The amorphous silicon layer becomes polycrystallized by this solid phase recrystallization annealing, and the average grain size of silicon in the gate electrode becomes about 1 to 3µm containing many of ≥ 5µm in size. Laser beam annealing, halogen lamp annealing, and the like are also good besides N₂ annealing. In the case laser beam or halogen lamp annealing is employed, the annealing time can be shortened compared to N₂ annealing. The P or B element, which was introduced during the film growth is activated in the annealing process concurrently. As a result, the resistivity of polycrystalline gate electrode 105 in both N⁺ polycrystalline silicon and P⁺ polycrystalline silicon becomes 1 to 3 x 10⁻³ Ω·cm, and when it is compared to the resistivity of 2.5 x 10⁻³ Ω·cm which is that of an N type doped gate electrode employing polycrystalline silicon formed by conventional LPCVD with an average grain size of ≤0.3 µm and not containing grains of ≥1µm at all, approximately the same level of resistivity can be obtained.

Fig. 5(d) shows a process wherein a source region 508 and a drain region 507 are formed by implanting P⁺ ions in the case of an N channel TFT and B⁺ ions in the case of a P channel TFT, employing the gate electrode 505 as a mask. After this step, N₂ annealing is performed at about 800°C to 1,000°C so that the source and drain regions are activated. As a result of this annealing, B or P in gate electrode 105 is completely activated and an increase in crystallized volume fraction is achieved at the same time, and the resistivity of N⁺ polycrystalline silicon and P⁺ polycrystalline silicon lowers to approximately 1 x 10⁻³ Ω·cm.

ECR PCVD is also suitable for forming an amorphous silicon film for the gate electrode. The hydrogen content in an amorphous silicon layer formed by ECR-PCVD can be reduced, therefore, it has the advantage of omitting the preannealing process for hydrogen removal. It is also good to form the amorphous silicon layer by remote plasma CVD at a substrate temperature of over 370°C as is described in Journal of Noncrystalline Solids Vol. 107, P. 295 (1989) and the like. By following this method, hydrogen contained in an amorphous silicon layer can be removed almost completely, so it is more suitable for solid phase deposition.

Fig. 5(e) shows a process of forming an interlevel insulator comprising an SiO₂ layer 509 by CVD, PCVD, sputtering, or the like. A silicon nitride film can also be employed as an interlevel insulator. At this stage, if hydrogen is introduced into the polycrystalline layer 502 by a hydrogen plasma method, hydrogen ion implantation, a hydrogen diffusion method from a plasma nitride film, or the like, then dangling bonds at Si/SiO₂ interface, grain boundaries, or the like, can be terminated by hydrogen atoms, providing the effect to decrease trap state density. This hydrogenation process can be performed before depositing the interlevel insulator.

Fig. 5(f) shows a process wherein source and drain contact holes are made, and a metal film, for example, Al for interconnections is deposited by sputtering or the like at a thickness of about 0.8 µm to form source electrode 511 and drain electrode 510.

Although an amorphous substrate, such as a quartz substrate was used in the foregoing description, the substrate could be crystalline, such as sapphire, CaF₂, or the like.

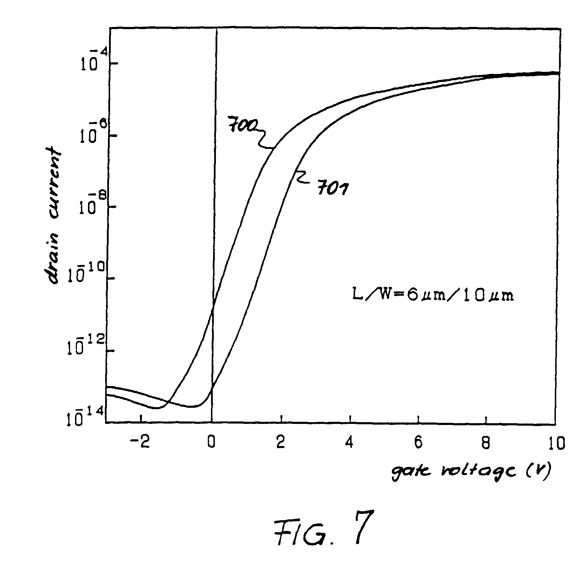

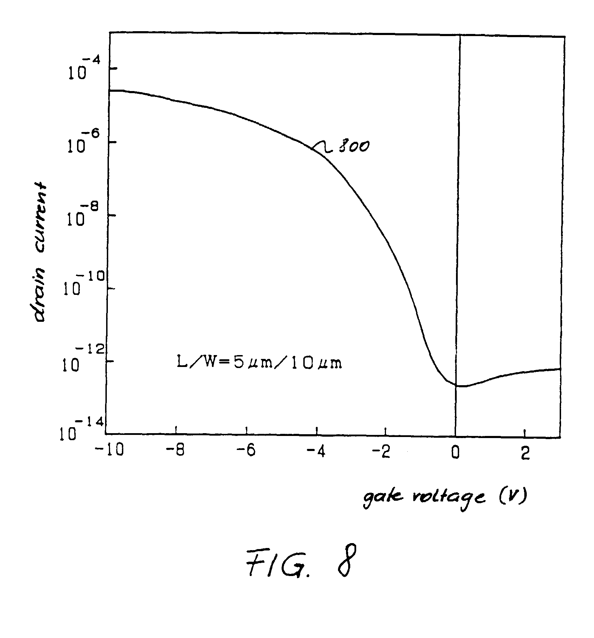

Fig. 7 and Fig. 8 show the characteristics of the TFT in the case p⁺ polycrystalline silicon is employed for the gate electrode. Fig. 7 shows the characteristics of drain current versus gate voltage of an n channel TFT, and Fig. 8, that of a p channel TFT. In the case wherein p type polycrystalline silicon is employed for the gate electrode, the voltage for forming a flat band condition in the structure of gate electrode/insulator film/semiconductor becomes about 1V higher than in the case an n type polycrystalline silicon gate is employed. On the other hand, it is known that conventional hydrogenated non-doped polycrystalline silicon shows slightly n type characteristics. For this reason, when an n type polycrystalline silicon gate electrode was employed in an n channel TFT, the gate voltage which would cause the drain current to be minimum was about -1V (Fig. 7, 700). On the other hand, when a p type polycrystalline silicon gate electrode was employed, Vth shifted to a positive value, and the gate voltage which caused the drain current to be minimum was close to 0V (Fig. 7, 701). In a p channel TFT, when n type polycrystalline silicon is employed as the gate electrode, the gate voltage which causes the drain current to be minimum is about -0.5V, however, even when a p type polycrystalline silicon gate is employed, the shift of Vth does not occur to the degree that the OFF current increases, therefore, good characteristics can be obtained (Fig. 8, 800). Thus, when a p type polycrystalline silicon gate electrode is employed, good TFT characteristics can be obtained in both p channel and n channel without increasing the number of processes. Therefore, channel doping which is inevitable when n⁺ polycrystalline silicon is employed as a gate electrode becomes unnecessary.

According to the manufacturing method described above, decreasing interconnect resistance which was difficult with a polycrystalline silicon formed by the prior art LPCVD can be achieved by an extremely easy process. Therefore, decreasing the gate interconnect resistance, which was a problem of an active TFT type large liquid crystal display panel of the prior art, can be easily achieved, giving the possibility of an easy application to HDTV with a liquid crystal display panel.

Also, in the case this invention is applied to a contact type image sensor wherein a scanning circuit and an optoelectric transducer are integrated on the same substrate, it substantially contributes to achieve faster read speed, higher resolution, and a wider gray-scale. Further, decreasing the resistance of gate interconnections made it possible to enlarge a contact type image sensor, contributing to achieve a larger size image sensor. In the same manner, applications on a TFT driven liquid crystal shutter array, TFT driven thermal head, and the like have also become possible. Still further, not only on TFTs, but also applications on three dimensional SOI elements and the like are possible.

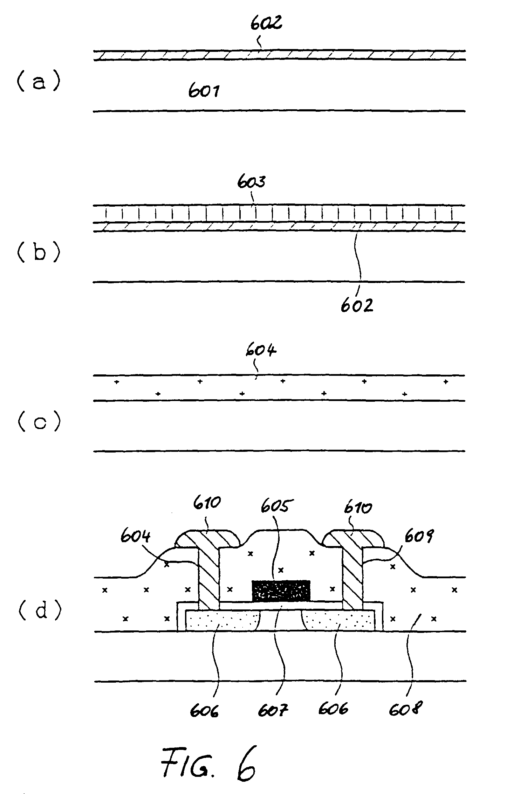

Next, Fig. 6 shows another example of a manufacturing process of a semiconductor device of this invention. Fig. 6 shows an example case wherein a TFT is formed as a semiconductor device. Fig. 6(a) shows a process wherein a first silicon layer 602 is formed over insulating material 601 comprising an insulating substrate, such as glass or quartz or the like, an insulating material layer, such as SiO₂ or the like, or others. The effective means of forming the first silicon layer is, for example, forming a silicon film of about 5 nm to 0.1 µm at a fairly high temperature of about 400°C to 800°C by plasma CVD or by a similar means. A thus formed silicon film has a higher crystalline nucleus generation rate by thermal treatment compared to an amorphous silicon film, used for a solar cell and the like, which was formed by plasma CVD at a temperature of less than about 350°C. Particularly, if the temperature of forming a film becomes over about 550°C, grains with orientation of <110> start to exist, and said grains become nuclei by thermal treatment, thus creating polycrystalline silicon with orientation of <110>.

Also, the means of forming the said film is not limited to this method, but the important thing is that it forms a silicon film whose polycrystalline nucleus generation rate by a thermal treatment at about 550°C to 650°C is higher than that of a second silicon layer (preferably less than one crystalline nucleus in 1µm²). Fig. 6 (b) shows a process of forming said second silicon layer 603 over said first silicon layer 602. An effective method of forming the second silicon layer is, for example, forming a film of about 10 nm to 0.3 µm at a relatively low temperature of about 150°C to 300°C by plasma CVD. However, the means of forming the film is not limited to that. The important thing is to form silicon whose polycrystalline nucleus generation rate is lower than that of the first silicon film (preferably polycrystalline nuclei will not be generated if thermal treatment at about 550°C to 650°C is performed for several tens of hours). Fig. 6(c) shows a process of performing thermal treatment on the first and second silicon layers for crystal growth. The best temperature for the thermal treatment differs depending upon how the first and the second silicon layers were formed, however, polycrystalline silicon layer 604 is formed by performing thermal treatment in an inert gas atmosphere of nitrogen, argon, or the like at 550°C to 650°C for about 1 to 10 hours. Also, thermal treatment in an atmosphere containing hydrogen contributes to decrease the defect density in the film.

Further, in the case a silicon layer is formed by plasma CVD, the film contains a large amount of hydrogen. If appropriate thermal treatment is performed to remove hydrogen before said thermal treatment at about 550°C to 650°C, the crystalline quality of the formed polycrystalline layer improves. For example, (1) performing thermal treatment at about 400°C to 500°C for 10 minutes to one hour, (2) controlling the speed of the temperature rise when raising the temperature to the thermal treatment temperature of 550°C to 650°C (for example, slow down the temperature rise speed to less than 20°C/min) and the like are effective. Further, the means of raising the temperature are not limited to those mentioned above, but the various methods shown in Fig. 2 are also effective.

The supposed mechanism of crystal growth is as follows: First, by short thermal treatment, crystalline nuclei are generated in the first silicon layer. Next, both the first and the second silicon layers are crystallized from these crystal nuclei, and the polycrystalline silicon layer 604 with large grains is formed. Especially, in the case the first silicon layer is formed by plasma CVD at a relatively high temperature (over about 550°C), then since the orientation of the grains which will become crystalline nuclei is <110> a polycrystalline silicon film with large grains with the orientation of <110> can be obtained by thermal treatment.

Fig. 6(d) shows the process of forming a semiconductor device on the silicon layer after crystal growth. Fig. 6(d) shows an example of forming a TFT as a semiconductor device. In this figure, 605 is a gate electrode, 606 are source and drain regions, 607 is a gate insulation film, 608 is an interlevel insulator, 609 are contact holes, and 610 are interconnections. One example of forming a TFT is to pattern the polycrystalline silicon layer 604 and to form a gate insulation film. The means of forming said gate insulation film is thermal oxidation (high temperature process) and CVD, or plasma CVD or the like wherein the processing temperature is below about 600°C (low temperature process). In the low temperature process, since an inexpensive glass substrate can be employed as a substrate, semiconductor devices, such as large liquid crystal display panels, contact type image sensors, and the like can be manufactured at low cost. Also, in the case of forming a three dimensional IC, a semiconductor element can be formed on the top layer without giving bad effects, (for example, diffusion of impurities) to the elements on a lower layer.

Next, after the gate electrode has been formed, the source and drain regions are formed by ion implantation, thermal diffusion, plasma doping, or the like, and the interlevel insulator is formed by LPCVD, sputtering, plasma CVD, or the like. Further, the contact holes are made in said interlevel insulator, and interconnections are formed to complete the TFT.

The field effect mobility of a high temperature processed TFT (N channel) manufactured by the method according to this invention is more than about 200cm²/Vsec, i.e. a high quality TFT is achieved. Also, the field effect mobility of a low temperature processed TFT (N channel) has been realized at about 100 to 150cm²/Vsec, and compared to the case the orientation is not controlled (relatively many grains with <111> orientation), the field effect mobility has improved in both cases. Further, the Si/SiO₂ interface state density decreased to half. This realization is a result of being able to form large grain polycrystalline silicon films with good reproducibility and being able to control the orientation by following the manufacturing method of this invention.

Also, this invention is a very effective manufacturing method when it is applied to insulating gate type semiconductor elements in general besides the TFT shown in the embodiment in Fig. 6.

Next, technological background which led to this invention is described. The method of forming a film and the thermal treatment conditions at the time of solid phase recrystallization are adjusted to the best in order to form polycrystalline silicon with larger grains and high orientation. As a result, the following became evident. (1) Polycrystalline nucleus generation density by thermal treatment and the time until the generation of polycrystalline nuclei vary depending upon how amorphous silicon was formed. (2) A silicon film formed by plasma CVD becomes a micro-crystalline silicon wherein crystalline regions exist in amorphous phase when RF power, film growth temperature, and the like are optimized. Especially, when the film growth temperature is over 400°C, preferably over 550°C, and RF power is optimized, the orientation of said crystalline region becomes <110>. (3) Even if the film growth conditions are the same, if the film thickness is thinner, then there is a tendency for polycrystalline nucleus generation density to become low. (4) The crystal nucleus generation rate of an amorphous silicon film formed by vacuum vapor deposition or plasma CVD (film growth temperature lower than 400°C) is low. When vacuum vapor deposition is taken as an example, an amorphous silicon film formed under the vacuum level of lower than 10⁻⁶Pa, at the substrate temperature of about 100°C, hardly any crystalline nucleus is generated after a thermal treatment at about 550°C to 650°C for about only 10 hours. Also, in the case of plasma CVD, when the film deposition conditions are adjusted to the best, such as, the film deposition temperature to lower than about 400°C (preferably lower than 200°C) and the RF power, hardly any crystalline nuclei are generated by a thermal treatment at about 550°C to 650°C for only about 10 hours.

Based on the result mentioned above, Fig. 6 illustrates a manufacturing process of this invention, which is the result of studies in order to form polycrystalline silicon with large grains. Its technological key point is enabling to produce a polycrystalline silicon film with large grains via a short thermal treatment by solid phase recrystallization combining a silicon layer which has a small polycrystalline nucleus generation rate and a silicon layer whose polycrystalline nucleus generation rate is relatively high.

Also, it became evident that if a natural oxide film existing on a first silicon layer is removed when depositing a second silicon layer, then the film quality and the crystalline quality improve. The oxide film on a first silicon layer can be removed if thermal treatment in hydrogen gas atmosphere, hydrogen plasma atmosphere, or the like is performed before a second silicon layer is placed over the first silicon layer. The method of forming a first silicon layer and a second silicon layer continuously without breaking vacuum is also effective. Especially, in the case both a first and a second silicon layer are formed by plasma CVD, by just using reactive "multiple in-line" chambers, a continuous film forming equipment with high mass productivity can be made easily. It is effective to have a cooling chamber between the reactive chambers for forming the first silicon layer and the reactive chamber for forming the second silicon layer to increase throughput. (Because the film growth temperature of the first silicon layer is higher.)

Next, the distinctive characteristics of this invention are described by comparing the cases wherein only either a first or second silicon layer is formed by solid phase recrystallization.

The purpose of this invention is to produce large grain polycrystalline silicon by a short thermal treatment using an easy manufacturing process. There is a drawback because a long thermal treatment is necessary in the case only a second silicon layer is formed by solid phase recrystallization. If the temperature of the thermal treatment is raised to, for example, over 800°C in order to shorten the time of thermal treatment, polycrystalline nucleus generation density becomes high abruptly, therefore, only polycrystalline silicon with a grain size of 0.02 to 0.03 µm at the largest can be obtained.

Also, when solid phase recrystallization is performed only on a first layer, the film thickness cannot be controlled freely because it would lower the polycrystalline nucleus generation density. However, when the combined structure of a first silicon layer and a second silicon layer is employed, it has an advantage of enabling the control of the thickness of the first silicon layer, which generates crystalline nuclei. In other words, as it was mentioned before, when the film growth conditions are the same, the thinner the film thickness is, the smaller the polycrystalline nucleus generation density becomes. For example, if a first silicon layer is formed thin at about 5 nm to 10 nm, it is possible to produce the remaining film thickness by a second silicon layer, thus enabling to obtain large grain polycrystalline silicon.

Further, Fig. 6 shows an example wherein a silicon layer whose crystalline nucleus generation rate is low is combined over a silicon layer whose crystalline nucleus generation rate is relatively fast. However, the order of layers can be reversed. In other words, a silicon layer whose crystalline nucleus generation rate is relatively fast can be placed over a silicon layer whose crystalline nucleus generation rate is low.

Also, in Fig. 6 after a first silicon layer and a second silicon layer are combined, solid phase recrystallization by thermal treatment is performed, however, the manufacturing process is not limited to that. Another method is, for example, after performing solid phase recrystallization by thermal treatment after a first silicon layer has been formed, to place a second silicon layer over the first silicon layer, then again to perform a thermal treatment for solid phase recrystallization.

This invention is a very effective manufacturing method in the case insulated gate type semiconductor elements in general, other semiconductor elements, such as bipolar transistors, static induction type transistors, optoelectric transducers, such as solar cells, optical sensors, and the like are formed employing polycrystalline semiconductors as element materials, besides the TFTs shown in the embodiments in Figs. 1, 4 ,5 and 6.

As described before, by following this invention, polycrystalline silicon films with large grains and a high crystallized volume fraction can be produced by an easy manufacturing process. As a result, it became possible to form high quality semiconductor elements on insulating materials, thereby making it possible to produce large size, high resolution liquid crystal display panels, high speed, high resolution contact type image sensors, three dimensional ICs and the like.

For example, in the case this invention is applied to a contact type image sensor wherein an optoelectric transducer and a scanning circuit are integrated in one chip, a fast scan speed (≤1 msec/line for A4-size paper), and a higher resolution (≥500 DPI) will be achieved. Also, there are other merits, such that the device can be operated by a lower source voltage (previously, about 16V were necessary which could be reduced to about 5V to 10V).

Also, according to the manufacturing method of a semiconductor device of this invention, there are the following effects. In the case of the channel region being non-doped, since the characteristics of an N channel polycrystalline silicon TFT tends to shift to the depletion side, and of a P channel to the enhancement side, it was previously necessary to dope boron in the channel region by ion implantation. On the other hand, according to this invention, since a doped polycrystalline silicon layer can be obtained by doping impurities, such as boron or the like at the time of film growth and then perform solid phase recrystallization, (1) an expensive equipment, such as an ion implantation system is not necessary and (2) there is no increase in the number of processes, therefore, it is very advantageous as to the costs.

Also, according to the manufacturing method of a semiconductor device of this invention, reduction of gate interconnect resistance, which is difficult with polycrystalline silicon formed by the prior art LPCVD, can be achieved easily by an extremely easy process. Therefore, gate interconnect resistance, which has been a problem of an active TFT large liquid crystal display panel, can be reduced, thereby enabling the application to a liquid crystal display panel for HDTV and the like easyily. Other than what was mentioned above, this invention is also effective when it is applied to a contact type image sensor wherein a scanning circuit and an optoelectric transducer are integrated on one substrate, thereby achieving faster read speed, higher resolution, and the like. Also, it is now possible to make a wider contact type image sensor because of the reduction of the resistance of the gate interconnections, rendering larger size image sensors. In the same manner, applications to TFT driven liquid crystal shutter arrays, TFT driven thermal heads, three dimensional ICs or the like are also possible.

Also, polycrystalline silicon layers with large grains can be formed by a short time thermal treatment by combining a layer wherein crystalline nuclei are generated easily and a layer wherein crystalline nuclei are hard to be generated by solid phase recrystallization. Further, by forming a layer wherein crystalline nuclei are generated easily by relatively high temperature plasma CVD, polycrystalline silicon with large grains with particular direction of orientation, such as <110> or the like can be obtained by short time thermal treatment. As a result, an improvement of the field effect mobility, reduction of Si/SiO₂ interface state density, and the like have been realized.

This invention is a very effective manufacturing method for the application on insulated gate type semiconductor elements in general and also other semiconductor elements, such as bipolar transistors, static induction transistors, optoelectric transducers, such as solar cells, optical sensors and the like which are formed employing polycrystalline semiconductors as element materials, besides the TFTs shown in the embodiments in Figs. 1, 4, 5 and 6.

## Claims

1. A method of manufacturing a semiconductor device comprising the steps:
(a) forming a noncrystalline semiconductor layer (102) mainly composed of silicon on an insulating material (101), and
(b) performing a thermal treatment for solid phase recrystallization on said noncrystalline semiconductor layer,
**characterized** by the subsequent steps
(c) raising the temperature at a speed lower than 20°C/min during a certain time to a prescribed temperature higher than the temperature of said thermal treatment, and
(d) forming a gate insulation film by thermal oxidation.

2. The method according to claim 1 wherein said prescribed temperature is 700°C to 1,200°C.

3. The method according to claims 1 or 2 wherein step (a) comprises forming of a-silicon by plasma CVD.

## Patentansprüche

1. Verfahren zur Herstellung einer Halbleitervorrichtung mit den Schritten:
(a) Ausbilden einer sich hauptsächlich aus Silizium zusammensetzenden nichtkristallinen Halbleiterschicht (102) auf einem isolierenden Material (101), und
(b) Durchführen einer thermischen Behandlung zur Festphasen-Rekristallisation an der nichtkristallinen Halbleiterschicht,
**gekennzeichnet** durch die nachfolgenden Schritte
(c) Anheben der Temperatur mit einer Geschindigkeit, die niedriger als 20°C/min ist, während einer bestimmten Zeit auf eine vorgegebene Temperatur, die höher ist als die Temperatur der thermischen Behandlung, und
(d) Ausbilden eines Gate-lsolierfilms durch thermische Oxidation.

2. Verfahren nach Anspruch 1, bei dem die vorgegebene Temperatur 700°C bis 1200°C ist.

3. Verfahren nach Anspruch 1 oder 2, bei dem der Schritt (a) das Ausbilden von a-Silizium durch ein Plasma-CVD-Verfahren umfaßt.

## Revendications

1. Procédé de fabrication d'un dispositif à semi-conducteur comportant les étapes qui consistent à :
(a) former une couche (102) semi-conductrice non cristalline composée principalement de silicium sur un matériau (101) isolant, et
(b) effectuer un traitement thermique pour une recristallisation en phase solide sur la ccuche semiconductrice non cristalline,
caractérisé par les étapes suivantes qui consistent à :
(c) élever la température à une vitesse inférieure à 20°C/mn pendant un certain temps jusqu'à une température prescrite supérieure à la température du traitement thermique, et
(d) former un film d'isolation de grille par oxydation thermique.

2. Procédé suivant la revendication 1, dans lequel la température prescrite est comprise entre 700°C et 1200°C.

3. Procédé suivant la revendication 1 ou 2, dans lequel l'étape (a) comporte le fait de former un a-silicium par dépôt par réaction chimique en phase vapeur (CVD) activé par plasma.
